# EUROPEAN PATENT APPLICATION

(11) **EP 2 110 858 A2**
(43) Date of publication of application: **21.10.2009**
(21) Application number: 09156389.0
(22) Date of filing: 27.03.2009
(51) Int. Cl.: H01L 31/0296, H01L 31/0352, H01L 31/0224

(54) **Visible-range semiconductor nanowire-based photosensor and method for manufacturing the same**

(30) Priority: 17.04.2008 KR 20080035505
(71) Applicant: KOREA INSTITUTE OF SCIENCE AND TECHNOLOGY, Seongbuk-gu Seoul (KR)
(72) Inventor: Choi, Kyoung Jin, Seoul (KR); Park, Jae Gwan, Seoul (KR); Kim, Dong Wan, Seoul (KR); Choi, Young Jin, Seoul (KR); Park, Kyun Soo, Seoul (KR); Park, Jae Hwan, Seoul (KR); Pyun, Jae Chul, Seoul (KR)
(74) Representative: Hannke, Christian

(57) **Abstract**

A semiconductor nanowire-based photosensor includes a substrate, at least a top surface of the substrate being formed of an insulator, two electrodes spaced at a predetermined interval apart from each other on the substrate, metal catalyst layers disposed respectively on the two electrodes, and visible-range semiconductor nanowires grown from the metal catalyst layers on the two electrodes. The semiconductor nanowires grown from one of the metal catalyst layers are in contact with the semiconductor nanowires grown from the other metal catalyst layer, while the semiconductor nanowiers grown respectively from the metal catalyst layers on the two electrodes are floated between the two electrodes over the substrate.

## Description

### CROSS-REFERENCE TO RELATED APPLICATIONS

This application claims the priority of Korean Patent Application No. 2008-35505 filed on April 17, 2008, in the Korean Intellectual Property Office, the disclosure of which is incorporated herein by reference.

### BACKGROUND OF THE INVENTION

### Field of the Invention

The present invention relates to a semiconductor nanowire-based photosensor, and more particularly, to a photosensor with high sensitivity and fast responsible time which uses semiconductor nanowires sensitive to light in the visible range as photosensitive material, the semiconductor nanowires floated between two electrodes, and a method for manufacturing the photosensor.

### Description of the Related Art

Due to new characteristics and functions of one-dimensional nanowires such as the dimension of a nanometer unit, a quantum confinement effect, a high single crystallinity, self-assembly, an internal stress reduction effect, and a high surface area-to-volume ratio (which may not be found in a traditional bulk material), the one-dimensional nanowires have received a great deal of attention as a potential material for providing various possibilities to electronic devices. The one-dimensional nanowires with a form similar to carbon nanotubes have excellent optoelectronic characteristics, and synthesis of various compositions for nanowires is possible.
Semiconductor physical properties and optoelectronic characteristics of nanowires can be controlled through doping with ease. Therefore, synthesis, modification, and device realization of the nanowire have been studied world-widely.
Compared to top-down fabrications based on photolithography processes of conventional thin films, the bottom-up method can be utilized to synthesize well-controlled one-dimensional nanostructures, to realize a highly integrated device, and to offer possibilities of new concept devices.

The semiconductor nanowires used for applications to various devices such as a laser device, a Field Effect Transistor (FET), a logic gate, and a chemical/bio photosensor are currently reported. Especially, by using excellent crystal properties and optoelectronic characteristics of the semiconductor nanowires, various nano optoelectronic devices such as a semiconductor nanowire laser, a photosensor, and a photo waveguide have been studied and also related researches are in progress in order to realize nano-optoelectronic systems. Based on manufacturing techniques such as System-On-Package (SOP) and Micro Electro Mechanical System (MEMS), a series of techniques using the semiconductor nanowires as a light source, a signal transmission medium, and a detector are currently being developed. Especially, studies for applying the semiconductor nanowires to a photosensor have been reported. A photosensor, an optical switch, and an optical coupler operated in a wavelength range from ultraviolet to near-infrared rays may be required in multi-purpose manufacturing techniques such as SOP, System-In-Package (SIP), and MEMS. It is expected that a nanowire-based photosensor having excellent sensitivity and response time can be effectively utilized.

In order to realize the photosensor based on a semiconductor nano structure having high-sensitivity optoelectronic characteristics and accurately controlled optical characteristics, synthesis of a wideband semiconductor nano structures and composition design techniques are required as support. Since cadmium sulfide (CdS), cadmium selenide (CdSe), and a solid solution thereof have band gaps of a visible range from about 1.7 eV (730 nm) to about 2.4 eV (506 nm), they have many advantages for developing an optoelectronic device and also can be synthesized through a relatively simple process. Thus, they may be a promising material for a nano structure for an optoelectronic device. Additionally, when two materials of CdS and CdSe, each of which is a two-component system, are mixed to form a single compound solid solution, the energy band gap of the solid solution can be altered depending on a composition change. Therefore, this solid solution may be effectively utilized to optically respond to different range of visible spectrum.

However, in order to realize such a photosensor device based on nanowires, a high-cost and time-consuming e-beam lithography technique is routinely utilized to transfer patterns for making electrical contacts to nanowires. Additionally, before making contacts to the individual nanowire, complex processes including detachment from the substrate, dispersion in appropriate solvents, and alignment of nanowires are needed. Due to these difficulties in manufacturing processes, many photosensor devices based nanowires cannot be manufactured in a batch fabrication method in a large scale under a mass production. For this reason, photosensor devices and products using the nanowires are not being currently developed for practical use.

### SUMMARY OF THE INVENTION

An aspect of the present invention provides a visible-range semiconductor nanowire-based photosensor with an excellent photosensitivity and fast response/recovery time, which is easy to produce in a batch fabrication method in a large scale.

Another aspect of the present invention provides a method for manufacturing a visible-range semiconductor nanowire-based photosensor, which can be easily applied to semiconductor fabricating processes of a wafer scale by synthesizing semiconductor nanowires directly on the patterned electrodes of a photosensor without subsequent processes such as dispersion and alignment of nanowires to simplify manufacturing processes of the photosensor and reduce a manufacturing cost.

According to an aspect of the present invention, there is provided a semiconductor nanowire-based photosensor including: a substrate having a top surface formed of an insulator; two electrodes spaced at a predetermined interval apart from each other on the substrate; metal catalyst layers disposed respectively on the two electrodes; and visible-range semiconductor nanowires grown from the metal catalyst layers on the two electrodes, wherein the visible-range semiconductor nanowires grown from one of the metal catalyst layers are in contact with the visible-range semiconductor nanowires grown from the other metal catalyst layer while the visible-range semiconductor nanowires grown respectively from the metal catalyst layers on the two electrodes are floated between the two electrodes over the substrate.

The visible-range semiconductor nanowires grown respectively from the metal catalyst layers on the two electrodes may have a network structure where the visible-range semiconductor nanowires are weaved together and contacted with each other while floating between the two electrodes.

The nanowires may be formed of a semiconductor material selected from the group consisting of CdSₓSe₁₋ₓ (0≤x≤1) and ZnSₓSe₁₋ₓ (0≤x≤1).

Each of the two electrodes may be a platinum electrode. A thickness of the platinum electrode may range from 3000 Å to 8000 Å, and an interval between the two platinum electrodes may range from 5 µm to 20µm. The semiconductor nanowire-based photosensor may further include a titanium layer between the platinum electrode and the substrate. Each of the metal catalyst layers may be a gold (Au) catalyst layer. A thickness of the gold catalyst layer may range from 20 Å to 100 Å. The insulator may be at least one selected from the group consisting of SiO₂, AlN, Si₃N₄ and TiO₂.

According to another aspect of the present invention, there is provided a method for manufacturing a semiconductor nanowire-based photosensor including: forming two electrodes on a substrate, the two electrodes being spaced at a predetermined interval apart from each other; forming a metal catalyst layer on each of the two electrodes; and growing visible-range semiconductor nanowires from the metal catalyst layer on each of the two electrodes, wherein the semiconductor nanowires are grown such that the semiconductor nanowires grown from one of the metal catalyst layers are in contact with the semiconductor nanowires grown from the other metal catalyst layer while the semiconductor nanowires grown respectively from the metal catalyst layers on the two electrodes are floated between the two electrodes over the substrate.

The visible-range semiconductor nanowires may be grown such that the visible-range semiconductor nanowires grown respectively from the metal catalyst layers on the two electrodes have a network structure where the visible-range semiconductor nanowires are weaved together and contacted with each other while floating between the two electrodes. The nanowires may be formed of a semiconductor material selected from the group consisting of CdSₓSe₁₋ₓ (0≤x≤1) and ZnSₓSe₁₋ₓ (0≤x≤1).

In the step of forming the two electrodes, each of the two electrodes may be formed of platinum. A thickness of the electrode may range from 3000 Å to 8000 Å, and an interval between the two electrodes may range from 5 µm to 20µm. The metal catalyst layer may be formed of gold. A thickness of the metal catalyst layer of gold may range from 20 Å to 100 Å.

The step of growing the visible-range semiconductor nanowires may include: disposing the substrate in a reactor for synthesis of nanowires; increasing a temperature in the reactor up to a reaction temperature of 400 **°C** to 600 **°C** with a heating rate (a rate of temperature increase) of approximately 20 **°C**/min; and synthesizing the semiconductor nanowires of CdSₓSe₁₋ₓ (0≤x≤1) or 2nSₓSe₁₋ₓ (0≤x≤1) on the metal catalyst layer through a pulse laser deposition, while providing a carrier gas including H₂ and Ar to the substrate at the reaction temperature with 50 sccm to 200 sccm for 5 min to 30 min.

The method may be applied to wafer scale semiconductor processes for batch manufacturing of many photosensor devices. In the step of forming the electrodes, a plurality of pairs of electrodes may be formed on a wafer, each pair of electrodes including the two electrodes. The steps of forming the metal catalyst layer and growing the semiconductor nanowires are then performed on the plurality of the pairs of electrodes on the wafer to manufacture a plurality of photosensor devices on the wafer. The plurality of the manufactured photosensor devices are then separated into respective unit devices.

### BRIEF DESCRIPTION OF THE DRAWINGS

The above and other aspects, features and other advantages of the present invention will be more clearly understood from the following detailed description taken in conjunction with the accompanying drawings, in which:
FIG. 1 is a schematic perspective view of a semiconductor nanowire-based photosensor according to an embodiment of the present invention;
FIGs. 2A through 2C are cross-sectional views illustrating a manufacturing process of a semiconductor nanowire-based photosensor of FIG. 1;
FIG. 3A is an SEM (scanning electron microscope) photograph showing CdS nanowires of a semiconductor nanowire-based photosensor according to an embodiment of the present invention;
FIG. 3B is a TEM (transmission electron microscope) photograph showing the CdS nanowire;
FIG. 3C is a graph showing X-ray diffraction analysis patterns of CdSₓSe₁₋ₓ (0≤x≤1) nanowires;
FIG. 3D is a graph showing room temperature PL (photoluminescence) spectra of the CdSₓSe₁₋ₓ nanowires;
FIGS. 4A and 4B are SEM photographs showing CdS-CaSe solid solution nanowires grown on two electrodes spaced at a predetermined interval apart from each other, FIG. 4A being a photograph seen aslant from above and FIG. 4B being a photograph seen vertically from above;
FIG. 5 illustrates photocurrent responsivity curves of CdSₓSe₁₋ₓ nanowires of photosensors according to embodiments of the present invention, which are measured using ozone-free xeon light source;
FIG. 6 illustrates dynamic current behaviors of CdS nanowires of a photosensor according to an embodiment of the present invention, which are obtained by intermittently and periodically illuminating the CdS nanowires with light of about 2.48 eV;
FIG. 7 is a graph illustrating X-ray diffraction analysis patterns of ZnSₓSe₁₋ₓ nanowires of photosensors according to embodiments of the present invention;
FIG. 8 is a graph illustrating band gap energies according to the composition x of the ZnSₓSe₁₋ₓ nanowires;
FIG. 9 is a graph illustrating room temperature PL spectra of the ZnSₓSe₁₋ₓ nanowires; and
FIGs. 10A through 10D are cross-sectional views illustrating a manufacturing process of a plurality of semiconductor nanowire-based photosensors in wafer level according to an embodiment of the present invention.

### DETAILED DESCRIPTION OF THE PREFERRED EMBODIMENT

Unlike a prior art Field-Effect Transistor (FET) type photosensor structure or its fabricating method, the present inventors have manufactured a semiconductor nanowire-based photosensor without such processes as dispersion and alignment of nanowires by growing nanowires on two electrodes space apart from each other such that the nanowires grown on the respective electrodes are contacted with each other at a position floated up from the bottom (substrate) and connect between the two electrodes. According to the manufactured semiconductor nanowire-based photosensor of the present inventors, various drawbacks of the prior art FET type nanowire-based photosensor can be removed. In the prior art FET type nanowire-based photosensor, photocurrent flow passing through the nanowire is obstructed by a substrate contacting the nanowire between adjacent electrodes, and its electrical resistance is increased. However, the nanowire-based photosensor manufactured by the inventors can solve such a limitation. Additionally, it is confirmed that the semiconductor nanowire-based photosensor suggested by the inventors, which has a three-dimensional structure where the visible-range semiconductor nanowires (e.g., CdS- CdSe or ZnS-ZnSe solid solution nanowires) are floated to connect with each other, has much more excellent photosensor characteristics than a photosensor having a sensing material of a bulk or thin film type.

Hereinafter, exemplary embodiments of the present invention will now be described in detail with reference to the accompanying drawings. However, the exemplary embodiments of the present invention may be modified within various other forms, and the scope of the present invention is not limited to the following embodiments described below.

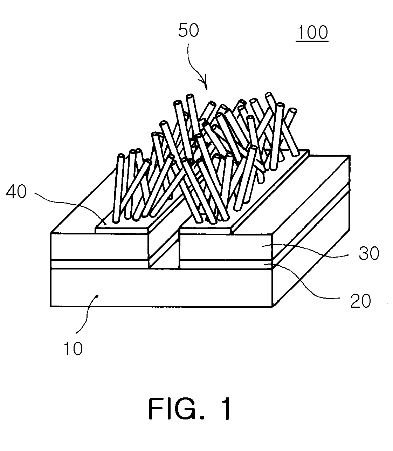

FIG. 1 is a schematic perspective view of a semiconductor nanowire-based photosensor according to an embodiment of the present invention. Referring to FIG. 1, the photosensor 100 includes a substrate 10 and electrodes 30 disposed thereon. The two electrodes 30 are spaced at a predetermined distance apart from each other and may be formed of platinum. A titanium layer 20 may be formed with the same pattern as the platinum electrode 30 between the platinum electrode 30 and the substrate 10. The titanium layer 20 serves as an adhesion layer for smooth attachment between the substrate 10 and the platinum electrode 30. The substrate 10 may be an insulator or at least the upper surface of the substrate 10 may be an insulator in order to insulate the two electrodes 30 from each other. For example, the substrate 10 may include Silicon semiconductor substrate on which an insulation layer is formed. The insulator may be SiO2, AlN, Si₃N₄ or TiO₂.

When platinum electrodes are used as the electrodes 30, the thickness of the platinum electrode 30 may range from about 3000 Å to about 8000 Å, and the interval between the two platinum electrodes 30 may range from about 5 µm to about 20 µm. A metal catalyst layer 40 is formed on at least a portion of the top surface of each platinum electrode 30, and visible-range semiconductor nanowires 50 are disposed on the metal catalyst layer 40. These semiconductor nanowires 50 are selectively grown on only an area where the metal catalyst layer 40 is disposed. Gold (Au) or nickel (Ni) may be used as the metal catalyst layer 40 and especially, a gold catalyst layer may be used for a semiconductor nanowire growth. The gold catalyst layer may have a thickness of about 20 Å to about 100 Å. The visible-range semiconductor nanowires 50 may be formed of one of cadmium sulfide (CdS), cadmium selenide (CdSe) and a solid solution (CdSₓSe₁₋ₓ (0≤x≤1)) thereof. Alternately, the semiconductor nanowires 50 may include at least two materials of cadmium sulfide (CdS), cadmium selenide (CdSe), and a solid solution (CdSₓSe₁₋ₓ) thereof. Besides a semiconductor material of CdSₓSe₁₋ₓ (0≤x≤1), a semiconductor material of ZnSₓSe₁₋ₓ (0≤x≤1) may be used as a material of the semiconductor nanowire 50. An energy band gap of semiconductor nanowires 50 of CdSₓSe₁₋ₓ (0≤x≤1) or ZnSₓSe₁₋ₓ (0≤x≤1) varies ranging from about 1.74 eV to about 2.45 eV (about 506 nm to about 713 nm) or ranging from about 2.65 eV to about 3.28 eV (about 378 nm to about 468 nm) according to a composition ratio x, respectively, which correspond to visible-range and a portion of ultraviolet ray.

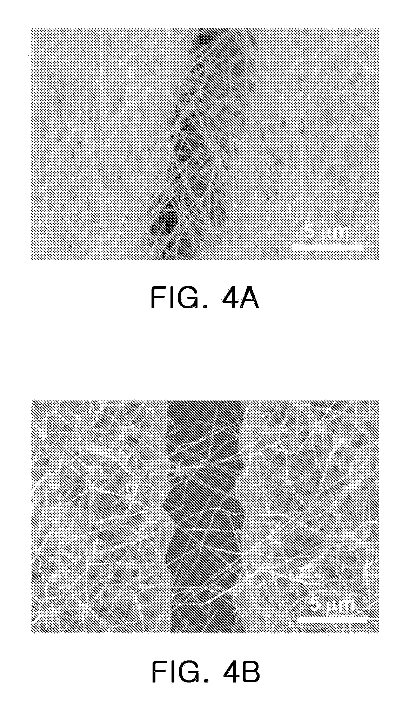

The semiconductor nanowires 50 grown respectively from the two metal catalyst layers 40 on the two electrodes 30, are contacted and connected with each other while the semiconductor nanowires 50 are floated and spaced apart from the substrate 10 between the two electrodes 30. For example, as illustrated in FIG. 1, the semiconductor nanowires 50 grown from the gold catalyst layer 40 on the left platinum electrode 30 extend with a wire form and the semiconductor nanowires 50 grown from the gold catalyst layer 40 of the right platinum electrode 30 extend with a wire form. The semiconductor nanowires 50 grown from both sides are weaved together and contacted with each other in the air in a network structure, that is, a web form (refer FIG. 4). The semiconductor nanowire 50 grown from the gold catalyst layer 40 on one platinum electrode 30 may be connected or contacted to the semiconductor nanowire 50 grown from the gold catalyst layer 40 on the other platinum electrode 30 through one-to-one correspondence. Additionally, one long semiconductor nanowire 50 grown from one of the two catalyst layers 40 may be connected or contacted to a plurality of semiconductor nanowires 50 grown from the other catalyst layer 40. In order to transmit an electrical signal to each platinum electrode 30, a conductive structure (not shown) such as a conductive line, a conductive pattern, or a wire may be connected to each platinum electrode 30.

By using the above mentioned nanowire structure where the semiconductor nanowires are directly grown from the sensor electrodes and also contacted to each other while floated between the two electrodes over substrate, an unsatisfactory situation in which electrical signal transmission reliability and sensor sensitivity are decreased due to the formation of a thin amorphous thin layer (that is, a bottom layer effect) on the substrate between the two electrodes can be effectively resolved.

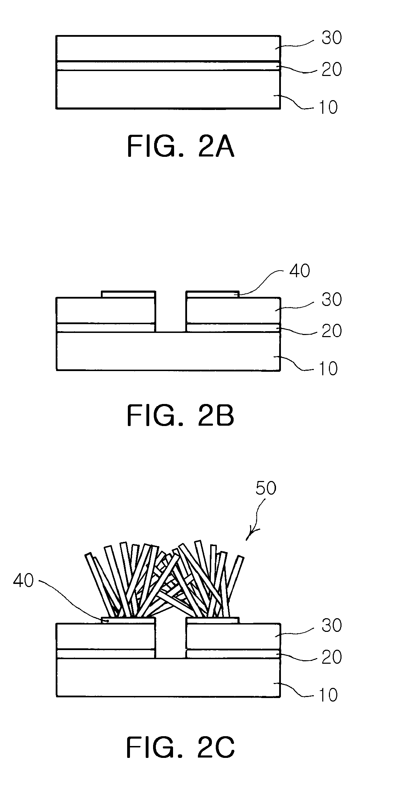

Hereinafter, a method for manufacturing a semiconductor nanowire-based photosensor will be described with preferred embodiments. The method for manufacturing a semiconductor nanowire-based photosensor according to one aspect of the present invention largely includes forming electrode structures of a photosensor (see FIGs. 2A and 2B) and growing visible-range semiconductor nanowires of CdSₓSe₁₋ₓ (0≤<x≤1) or ZnSₓSe₁₋ₓ (0≤x≤1) on the electrode structures (see FIG. 2C) . The semiconductor nanowires are grown such that the nanowires grown on the respective electrodes are contacted with each other while floated between the two electrodes over the substrate. Before growing the semiconductor nanowire, a metal catalyst layer 40 such as gold (Au) is formed on each electrode 30 (see FIG. 2B) . After manufacturing a photosensor device by growing the semiconductor nanowires, photosensitivity according to wavelength is measured for the manufactured photosensor.

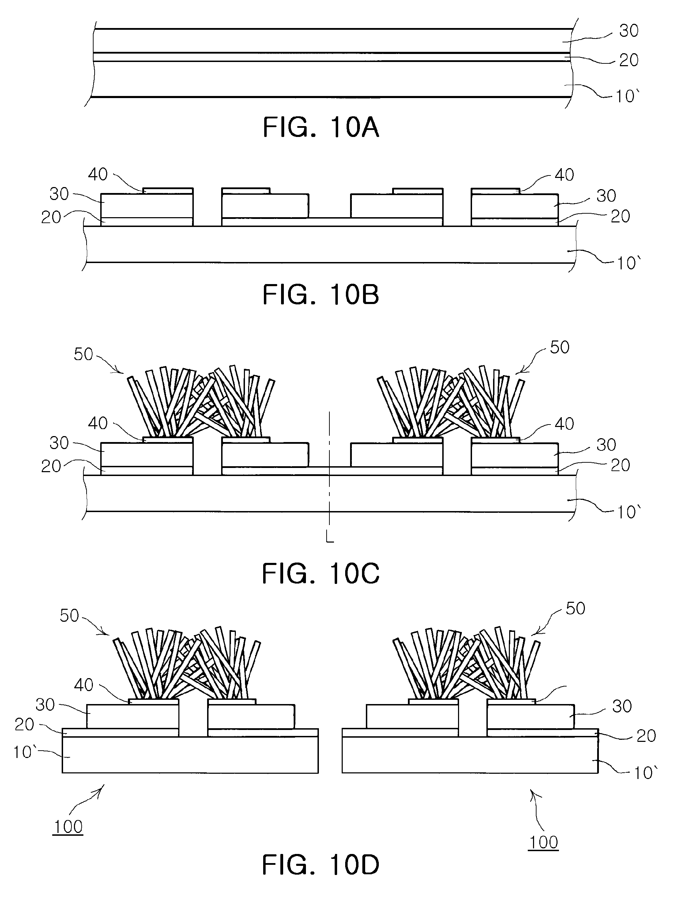

This method for manufacturing a semiconductor nanowire-based photosensor may be applied to wafer-scale semiconductor process for manufacturing a plurality of devices in batch fabrication. Referring to FIGs. 10A to 10D, pairs of electrodes 30 (one pair includes two electrodes 30) are formed on a wafer substrate 10' in the step of the formation of the electrodes 30. Then, the above-mentioned steps of forming gold catalyst layer 40 and forming the visible-range semiconductor nanowires 50 of CdSₓSe₁₋ₓ (0≤<x≤1) or ZnSₓSe₁₋ₓ (0≤x≤1) are performed on the plurality of the pairs of electrodes 30 by a wafer unit. After that, as illustrated in FIG. 10D, a plurality of devices manufactured on the wafer can be divided or separated into respective devices. For example, at the boundary L of the device areas on the wafer, the wafer substrate is cut or etched such that a separation process for each device can be performed. Therefore, wafer level mass production for the semiconductor nanowire-based photosensors can be realized.

EXAMPLES

[Manufacturing Electrodes of Nanowire-based photosensor]

It is effective that a gold catalyst layer is used in order to collectively arrange semiconductor nanowires between electrodes, which are formed on a wafer periodically, without performing a separate lithography on each semiconductor nanowire. In a case of CdS-CdSe solid solution nanowires, when the gold catalyst layer for semiconductor nanowire growth is formed with a thickness of about 20 Å to about 100 Å, the semiconductor nanowires are formed only at the region where the gold catalyst layer exists.

First, as illustrated in FIG. 2A, a titanium layer 20 of about 50 nm thickness and a platinum layer 30 are formed on a substrate 10 such as a silicon substrate at least which top surface is formed of an insulator (e.g., SiO₂, AlN, Si₃N₄ or TiO₂). As illustrated in FIG. 2B, through such processes as photolithography and lift-off, patterns of the platinum electrodes 30 are formed. The thickness of the platinum electrode 30 ranges from approximately 3000 Å to 8000 Å, and the two electrodes 30 are spaced apart from each other with the interval ranging from approximately 5 µm to 50 µm. Preferably, the interval of the two electrodes 30 may be between approximately 5 µm and 20 µm. If the interval is less than about 5 µm, it may be difficult to form the two respectively separated electrodes, and if the interval is more than about 20 µm, it may be difficult to transmit an electrical signal by light because nanowires grown on both electrodes 30 are spaced apart from each other.

The nanowires 50 may be effectively manufactured by forming the gold catalyst layer 40 on at least a portion of each platinum electrode 30, if possible, on respective specific areas adjacent to each other of the two platinum electrodes 30. In this case, degradation of electrical signal transmission property due to the amorphous thin layer (i.e., a bottom layer effect) formed between each electrode 30 and the nanowire 50 of CdSₓSe₁₋ₓ (0≤x≤1) can be prevented. Therefore, excellent responsivity characteristics to light can be effectively achieved. The gold catalyst layer 40 is formed with a thickness of approximately 20 Å to 50 Å through an ion sputtering process.

Along with the above mentioned electrode formation, a conductive structure (not shown) such as a conductive line, a conductive pattern and a wire, which is connected to each electrode 30, may be formed also for electrical signal transmission to the each electrode 30.

[Manufacturing Nanowires of CdSₓSe₁₋ₓ (0≤x<≤1) Floating above Manufactured Electrodes]

The growths of semiconductor wires 50 of CdS, CdSe and CdS-CdSe solid solution uses a pulsed laser deposition (PLD) method. In the PLD method, when a target surface is irradiated with a laser beam of high intensity, the target material instantly changes through the forms of liquid and vapor into a plasma state. Since the gaseous plasma formed through the PLD method has the same composition as the target, a composition design is relatively easy in case of manufacturing complex multi-component system materials in the PLD method. The PLD method with such merits is advantageous for manufacturing a solid solution nanowire of complex three component system compounds such as CdS-Se and ZnS-Se.

The semiconductor nanowires 50 are manufactured through the PLD method, under the conditions in which KrF gas is used as a laser generating source to employ an excimer laser for generating an ultraviolet beam of about 248 nm wavelength, laser repetition frequency and energy density being approximately 5 Hz and 5 J/cm², respectively.

As a laser target used in the PLD method for manufacturing CdS-CdSe solid solution nanowires, CdS nanowires and CdSe nanowires, five different kinds of targets including CdS, CdSe and three kinds of solid solutions (CdS_{0.75}Se_{0.25}, CdS_{0.50}Se_{0.50}, and CdS_{0.25}Se_{0.75}) are manufactured through solid-phase synthesis, which is a typical ceramic manufacturing process. The targets of CdSₓSe₁₋ₓ (x = 0, 0.25, 0.50, 0.75, 1) are manufactured by measuring CdS and CdSe powders based on each composition ratio, wet-mixing the powders using ethanol as a solvent, drying the mixure, molding the dried mixture in a cylindrical shape and then sintering the molded object.

For manufacturing CdSₓSe₁₋ₓ nanowires, after positioning the sintered target in the middle of a PLD reactor, the manufactured electrode patterns (including the gold catalyst layers formed on the platinum electrodes) are disposed in the front of the target. After increasing the temperature in the reactor up to a reaction temperature of about 500 °C with a heating rate of about 30 °C/min, about 100 sccm of Ar gas mixed with about 5 % H₂ is provided for 10 min while growing or synthesizing the semiconductor nanowires from the catalyst layers in the PLD method. During the synthesis of nanowires, a total pressure in the PLD reactor maintains about 2 Torr using a rotary pump.

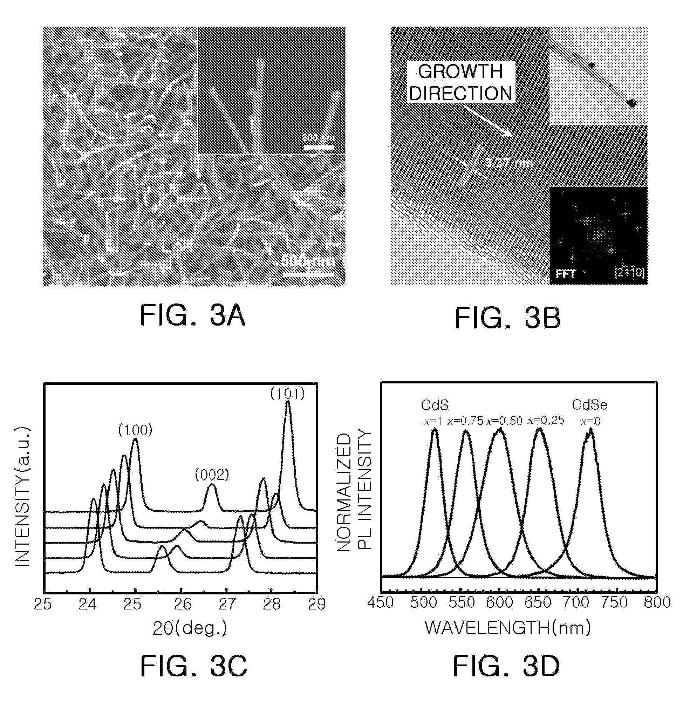

FIG. 3A is an SEM photograph showing CdS nanowires manufactured at the temperature of about 500 °C in the middle of a PLD reactor. As shown in the right upper portion of the FIG. 3A, a tip formed of an alloy of gold catalyst and CdS is observed at an end portion of the manufactured nanowire. The one-dimensional nanowire can be manufactured using catalyst, and can grow through Vapor-Liquid-Solid (VLS) process. The source material for nanowire reacts with the catalyst to form a eutectic alloy at the tip portion of the nanowire.

FIG. 3B is a TEM photograph showing the manufactured CdS nanowire. Through fast fourier transform (FFT) diffraction image, it is confirmed that the length direction of the nanowire is [002] direction. Through a high resolution lattice picture, it is confirmed that a single crystal nanowire without lattice defects can be manufactured.

FIG. 3C shows X-ray diffraction analysis patterns of CdSₓSe₁₋ₓ (0≤x≤1) nanowires. It is confirmed that the CdSₓSe₁₋ₓ solid solution nanowire is a complete solid solution without phase separation of CdS and CdSe and has a hexagonal crystal phase regardless of a change of a composition ratio (i.e., an x value) . As the x value is increased, diffraction peaks moves toward the higher diffraction angle. The lattice constant and the volume of a unit cell of the CdSₓSe₁₋ₓ nanowire are the results caused by the difference between the lattice constants (a=0.412 nm, c=0.668 nm) of CdS of hexagonal structure and the lattice constants (a=0.430 nm, c=0.701 nm) of CdSe of hexagonal structure, and this can be an evidence that the CdSₓSe₁₋ₓ solid solution nanowire is a complete compound solid solution.

FIG. 3D shows room temperature photoluminescence spectra of the manufactured CdSₓSe₁₋ₓ nanowires. In the CdSₓSe₁₋ₓ nanowires, according to the x value, strong Near Band Emission (NBE) peaks are observed at 1.74 eV (x=0), 1.95 eV (x=0.25), 2.11 eV (x=0.50), 2.26 eV (x=0.75), and 2.45 eV (x=1) . The NBE peaks correspond to the energy band gaps of the respective materials. It is confirmed that according to change of the x value of the CdSₓSe₁₋ₓ nanowire, the energy band gap can be adjusted within a range of about 1.74 eV to about 2.45 eV.

FIGs. 4A and 4B are SEM photographs showing CdS-CaSe solid solution nanowires manufactured on electrode patterns.
FIG. 4A shows the nanowires seen aslant from above at about 30°, the nanowires grown from the respective electrode patterns (left and right electrode patterns in the drawing) being contacted with each other between the electrode patterns while floating above a substrate. FIG. 4B is a plan view of the nanowires, which is seen vertically from above. It is observed that the nanowires grown from the two electrode patterns spaced apart from each other at a predetermined interval are connected to each other or weaved together to form a network structure while floating above the substrate between the two electrode patterns.

[photo-reponsivity Evaluation of CdSₓSe₁₋ₓ (0≤x≤1) Nanowires According to Wavelength change]

The change of photocurrent value of the CdSₓSe₁₋ₓ nanowire-based photosensor has been measured while irradiating the CdSₓSe₁₋ₓ nanowires with the light of a specific wavelength separated from a light source. The photo-responsivity measurement system uses ozone-free xenon light source and separates wavelengths of light emitted from the light source to direct the separated light to the photosensor device through a filter and lens. Then, the photo-responsivity measurement system measures the change of photocurrent value of the nanowire-based photosensor.

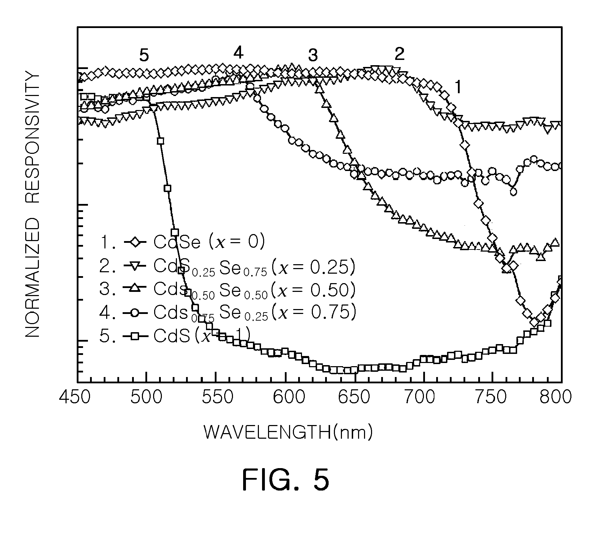

FIG. 5 illustrates photocurrent responsivity curves of the CdSₓSe₁₋ₓ nanowires measured at an energy range from about 1.55 eV to about 2.76 eV (about 450 nm to about 800 nm) using the ozone-free xeon light source. The photocurrent responsivity curves of the FIG. 5 are obtained by measuring the changes of photocurrent values while applying about 5 V to the nanowire-based photosensor devices. The responsivity of the CdSₓSe₁₋ₓ nanowires represents a drastic reduction of the photocurrent at a specific energy. It is measured that the photo-responsivity energies of the nanowires of CdSₓSe₁₋ₓ (x = 0, 0.25, 0.50, 0.75, 1) representing drastic changes are about 1.74 eV (x=0), about 1.95 eV (x=0.25), about 2.11 eV (x=0.50), and about 2.45 eV (x=1), respectively. These results correspond to the energy band gaps predicted from the photoluminescence spectra (refer to FIG. 3D) measured at room temperature.

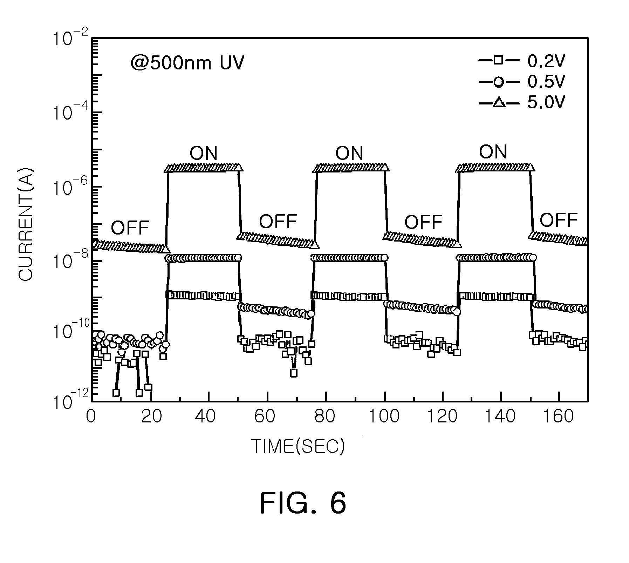

FIG. 6 illustrates dynamic current behaviors due to on/off of the CdS nanowires to which light of a specific energy (about 2.48 eV) is projected intermittently or periodically. According to whether the CdS nanowires are irradiated with the light of the specific energy or not, the photo-responsivity of the CdS nanowires exhibits almost 100 times difference at an applied voltage of about 5 V. This shows that the CdS nanowire-bsed photosensor operates with remarkably high sensitivity at a specific energy.

[Manufacturing ZnSₓSe₁₋ₓ (0≤x≤1) Nanowire-based photosensor]

Similarly to the above-mentioned method for manufacturing the CdSₓSe₁₋ₓ (0≤x≤1) nanowire-based photosensor, ZnSₓSe₁₋ₓ (0≤x≤1) nanowire-based photosensors are manufactured. Electrode structures of platinum electrodes and gold catalyst layers are formed on a substrate like the previous embodiments. Then, nanowires of ZnS, ZnSe and three kinds of solid solutions thereof (i.e., ZnS, 2nS_{0.75}Se_{0.25}, ZnS_{0.50}Se_{0.50}, and 2nS_{0.25}Se_{0.75}, ZnSe) are manufactured through the PLD method by using ZnS and ZnSe powders instead of CdS and CdSe powders as raw material for nanowires. The ZnSₓSe₁₋ₓ nano structures grown from the two respective electrode patterns are connected to each other, while floating between the two electrodes above the substrate.

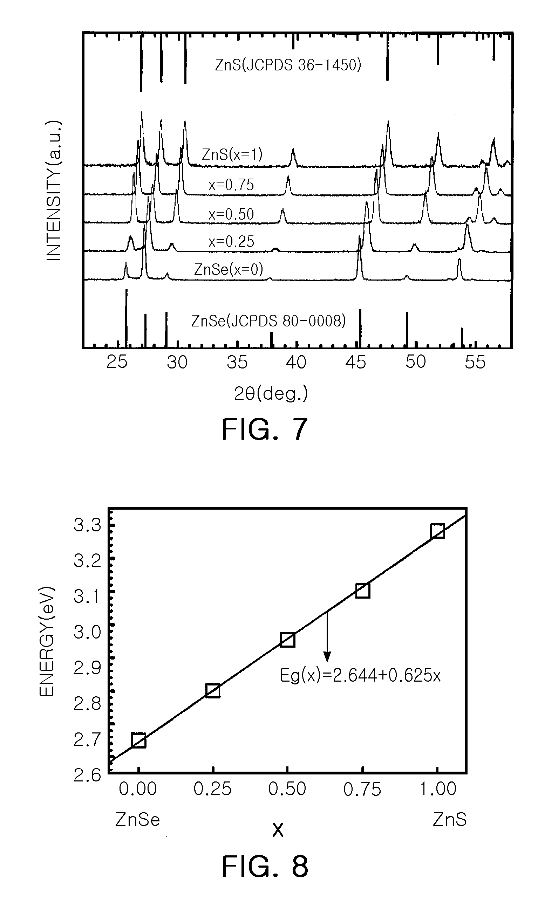

FIG. 7 is a graph illustrating X-ray diffraction analysis patterns of the manufactured ZnSₓSe₁₋ₓ nanowires. Referring to FIG. 7, it is confirmed that the ZnSₓSe₁₋ₓ solid solution nanowire is a complete solid solution without phase separation of ZnS and ZnSe and has a hexagonal crystal phase regardless of change of the composition ratio (i.e., an x value) .

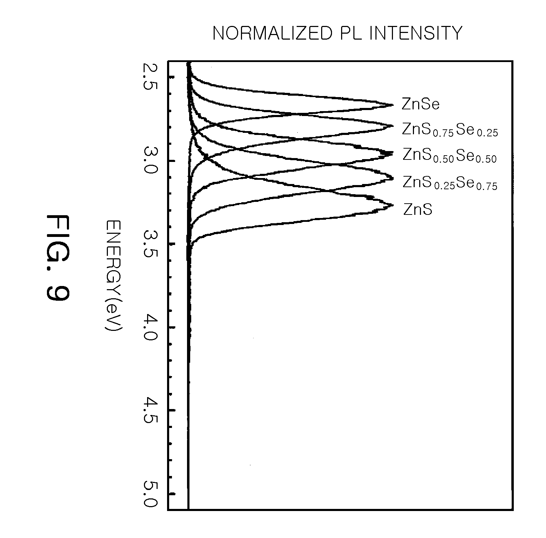

FIG. 8 is a graph illustrating band gap energies according to the composition x of the ZnSₓSe₁₋ₓ nanowires. FIG. 9 is a graph illustrating room temperature photoluminescence spectra of the 2nSₓSe₁₋ₓ nanowires. In the ZnSₓSe₁₋ₓ nanowires, strong NBE peaks are observed at about 2.65 eV (x=0), about 2.80 eV (x=0.25), about 2.95 eV (x=0.50), about 3.10 eV (x=0.75), and about 3.28 eV (x=1) according to the composition x. The NBE peaks corresponds to energy band gaps of the ZnSₓSe₁₋ₓ, and the energy band gap of the ZnSₓSe₁₋ₓ nanowire can be varied within a range from about 2.65 eV to about 3.28 eV according to the x value change of the ZnSₓSe₁₋ₓ nanowire. Accordingly, the ZnSₓSe₁₋ₓ (x = 0, 0.25, 0.50, 0.75, 1) nanowire-based photosensors represent changes of drastic photocurrent values at photon energies around about 2.65eV (x=0), about 2.80 eV (x=0.25), about 2.95 eV (x=0.50), about 3.10 eV (x=0.75) and about 3.28 eV (x=1).

Embodiments of the present invention provide a visible-range semiconductor nanowire-based photosensor having an excellent photosensitivity and fast response and recovery time. According to the nanowire-based photosensor structure and the method for manufacturing the same, a nanowire is manufactured on an electrode without subsequent processes such as dispersion and alignment of the synthesized nanowires to simplify manufacturing processes and reduce a fabrication cost. Therefore, this can be effectively applied to a semiconductor manufacturing process. Moreover, since the nanowire-based photosensor according to embodiments of the present invention can cover a full visible-range band as a responsivity band, it can be utilized as various nano photoelectric devices such as a photosensor, an optical switch, an optical coupler, which can operate in a broad application field.

While the present invention has been shown and described in connection with the exemplary embodiments, it will be apparent to those skilled in the art that modifications and variations can be made without departing from the spirit and scope of the invention as defined by the appended claims.

## Claims

1. A semiconductor nanowire-based photosensor comprising:
a substrate having a top surface formed of an insulator;
two electrodes spaced at a predetermined interval apart from each other on the substrate;
metal catalyst layers disposed respectively on the two electrodes; and
a plurality of visible-range semiconductor nanowires grown from the metal catalyst layers on the two electrodes,
wherein the visible-range semiconductor nanowires grown from one of the metal catalyst layers are in contact with the visible-range semiconductor nanowires grown from the other metal catalyst layer while the visible-range semiconductor nanowires grown respectively from the metal catalyst layers on the two electrodes are floated between the two electrodes over the substrate.

2. The semiconductor nanowire-based photosensor of claim 1, wherein the visible-range semiconductor nanowires grown respectively from the metal catalyst layers on the two electrodes have a network structure where the visible-range semiconductor nanowires are weaved together and contacted with each other while floating between the two electrodes.

3. The semiconductor nanowire-based photosensor of claim 1, wherein the nanowires are formed of a semiconductor material selected from the group consisting of CdSₓSe₁₋ₓ (0≤x≤1) and ZnSₓSe₁₋ₓ (0≤x≤1).

4. The semiconductor nanowire-based photosensor of claim 1, wherein each of the two electrodes is a platinum electrode.

5. The semiconductor nanowire-based photosensor of claim 4, wherein a thickness of the platinum electrode ranges from 3000 Å to 8000 Å, and an interval between the two platinum electrodes ranges from 5 µm to 20µm.

6. The semiconductor nanowire-based photosensor of claim 4, further comprising a titanium layer between the platinum electrode and the substrate.

7. The semiconductor nanowire-based photosensor of claim 1, wherein each of the metal catalyst layers is a gold (Au) catalyst layer.

8. The semiconductor nanowire-based photosensor of claim 7, wherein a thickness of the gold catalyst layer ranges from 20 Å to 100 Å.

9. The semiconductor nanowire-based photosensor of claim 1, wherein the insulator is at least one selected from the group consisting of SiO₂, AlN, Si₃N₄ and TiO₂.

10. A method for manufacturing a semiconductor nanowire-based photosensor, the method comprising:
forming two electrodes on a substrate, the two electrodes being spaced at a predetermined interval apart from each other;
forming a metal catalyst layer on each of the two electrodes; and
growing visible-range semiconductor nanowires from the metal catalyst layer on each of the two electrodes,
wherein the visible-range semiconductor nanowires are grown such that the visible-range semiconductor nanowires grown from one of the metal catalyst layers are in contact with the visible-range semiconductor nanowires grown from the other metal catalyst layer while the visible-range semiconductor nanowires grown respectively from the metal catalyst layers on the two electrodes are floated between the two electrodes over the substrate.

11. The method of claim 10, wherein the visible-range semiconductor nanowires grown respectively from the metal catalyst layers on the two electrodes have a network structure where the semiconductor nanowires are weaved together and contacted with each other while floating between the two electrodes.

12. The method of claim 10, wherein the nanowires are formed of a semiconductor material selected from the group consisting of CdSₓSe₁₋ₓ (0≤x≤1) and ZnSₓSe₁₋ₓ (0≤x≤1).

13. The method of claim 10, wherein each of the two electrodes is formed of platinum.

14. The method of claim 13, wherein a thickness of the electrode ranges from 3000 Å to 8000 Å, and an interval between the two electrodes ranges from 5 µm to 20µm.

15. The method of claim 10, wherein the metal catalyst layer is formed of gold.

16. The method of claim 15, wherein a thickness of the metal catalyst layer ranges from 20 Å to 100 Å.

17. The method of claim 10, wherein the step of growing the visible-range semiconductor nanowires comprises:
disposing the substrate in a reactor for synthesis of nanowires;
increasing a temperature in the reactor up to a reaction temperature of 400 **°C** to 600 **°C** with a heating rate of approximately 20 **°C**/min; and
synthesizing the semiconductor nanowires of CdSₓSe₁₋ₓ (0≤x≤1) or ZnSₓSe₁₋ₓ (0≤x≤1) on the metal catalyst layer through a pulse laser deposition, while providing a carrier gas including H₂ and Ar to the substrate at the reaction temperature with 50 sccm to 200 sccm for 5 min to 30 min.

18. The method of claim 10, wherein in the step of forming the electrodes, a plurality of pairs of electrodes are formed on a wafer, each pair of electrodes comprising the two electrodes spaced at a predetermined interval,
the steps of forming the metal catalyst layer and growing the semiconductor nanowires are performed on the plurality of the pairs of electrodes on the wafer to manufacture a plurality of photosensor devices on the wafer, and
the plurality of the manufactured photosensor devices are then separated into respective unit devices.
